# EUROPÄISCHE PATENTSCHRIFT

(11) **EP 0 821 079 B1**
(45) Veröffentlichungstag und Bekanntmachung des Hinweises auf die Patenterteilung: **29.12.1999**
(21) Anmeldenummer: 97111802.1
(22) Anmeldetag: 11.07.1997
(51) Int. Cl.: C23C 16/52, C23C 16/50

(54) **CVD-Verfahren und Vorrichtung zur Innenbeschichtung von Hohlkörpern**
CVD-Process and device for interior coating of hollow bodies
Procédé de DCV et dispositif pour revêtement de l'intérieur de corps creux

(30) Priorität: 24.07.1996 DE 19629877
(43) Veröffentlichungstag der Anmeldung: 28.01.1998
(73) Patentinhaber: Schott Glas, 55122 Mainz (DE); CARL-ZEISS-STIFTUNG trading as Schott Glas, 55122 Mainz (DE)
(72) Erfinder: Walther, Marten, 55270 Engelstadt (DE)
(74) Vertreter: Fuchs Mehler Weiss & Fritzsche

(56) Entgegenhaltungen:
- EP-A- 0 299 752
- DE-A- 3 830 622
- DE-A- 4 122 452
- DE-C- 4 008 405

## Beschreibung

Die Erfindung betrifft ein CVD-Verfahren zur Innenbeschichtung von Hohlkörpern, wie Flaschen, Ampullen oder dergleichen, mit mindestens einer Sperrschicht, wobei der Hohlkörper vor der Beschichtungsphase, während der Beschichtungsgas in den Hohlkörper eingeleitet wird, in einer Aufheizphase mittels eines Plasmas, insbesondere eines O₂-Plasmas, auf eine vorgegebene Temperatur erwärmt wird. Die Erfindung bezieht sich auch auf eine Vorrichtung gemäß dem Oberbegriff des Patentanspruchs 4.

Pharmazeutisches Packmaterial wie Injektionsflaschen, Ampullen oder dergleichen kann auf seiner Innenseite mit einer Sperrschicht versehen sein, damit das Herauslösen von Glasbestandteilen und deren Übertritt in die im Packmittel befindliche Flüssigkeit oder im Falle von Plastikverpackung das Eindringen von Fremdgasen verhindert wird. Es müssen daher sehr hohe Anforderungen an die Qualität solcher Sperrschichten gestellt werden. Da die Beschichtungsqualität am beschichteten Produkt nicht oder nur äußerst schwierig überprüft werden kann, muß das Beschichtungsverfahren kontrolliert werden, so daß aus den Prozeßparametern Rückschlüsse auf die Qualität der Beschichtung gezogen werden können.

Es ist bekannt, zur Untersuchung der in einem Plasma ablaufenden Reaktionen und zur Steuerung von Plasma-Beschichtungen und -Ätzungen neben elektrischen Meßmethoden (Langmuirsonde für Elektronen- und Ioneneigenschaften, Massenspektrometrie für Aufbau und Zerschlagung von gasförmigen Verbindungen im Plasma) die optische Emissionsspektroskopie (OES) einzusetzen. Die OES hat den Vorteil, daß sie im Gegensatz zu den anderen Meßmethoden "berührungslos", d.h. nicht im Kontakt zum Plasma oder zum untersuchenden Gas arbeitet und daß somit keine schädliche Wechselwirkung mit dem Untersuchungsobjekt stattfindet.

In "Thin Solid Films" 266(1995)8-13 wird beschrieben, daß die Mikrostruktur und die chemische Zusammensetzung eines abgeschiedenen Films aus dem System TiTP/N₂/N₂ aufgrund der Prozeßparameter variiert, wobei aus der optischen Emission des Gleichspannungsplasmas auf die Gaszusammensetzung und die Kathodentemperatur geschlossen werden kann.

Im Tagungsband 3 "10th International Symposium on Plasma Chemistry" (1991), 2.4-30 wird die Herstellung von La₂O₃-Schichten mit geringer C-Verunreinigung mittels HF-Plasma-CVD aus einer organischen La-Verbindung und Sauerstoff beschrieben und empfohlen, das Verhältnis der Intensitäten zweier Linien (CO und O₂+) zur Regelung des Dampfdrucks des La-Precursors auf einen festen Wert einzusetzen, damit ein C-Gehalt <3 % der Schicht gewährleistet wird.

In dem Buch "Plasmatechnik" von Schade, Suchanek und Tiller, erschienen 1990 im Verlag Technik GmbH Berlin, ist auf Seite 140 und 141 beschrieben, wie das zeitliche Verhalten der CO- und der AlCl-Emission oder in einem anderen Beispiel der Si-Emission als Prozeßkontrolle beim Plasmaätzen eingesetzt wird. Im letzteren Fall kann aus dem zeitlichen Verlauf der Emissionslinie eine Aussage über eine gute oder eine schlechte Ätzhomogenität getroffen werden.

In EP-0 299 752 ist ein Verfahren zur Überwachung und Steuerung von Plasma-CVD-Beschichtungen angegeben. Es besteht darin, daß die optische Plasmaemission gemessen und spektral analysiert wird und die Ergebnisse dazu verwendet werden, Plasmaeigenschaften zu regeln, um Schichten mit vorgegebenen Eigenschaften reproduzierbar herstellen zu können. Das für die Regelung maßgebliche Signal ist das Verhältnis zweier oder mehrerer charakteristischer Linien, die zu dem wichtigen Plasmaparameter Elektronentemperatur in einem festen Verhältnis stehen.

In der DE-38 30 622 wird ein gepulstes Plasma-CVD-Verfahren zur Innenbeschichtung von Quarzglasrohren beschrieben. Die spezifische Emission einer schichtbildenden Verbindung (SiO) wird dazu benutzt, die Länge und Lage des Plasmabereichs im Rohr, der zur Schichtbildung beiträgt, während der Beschichtung auf einen vorgegebenen Wert einzuregeln.

Aus der DE 4008405 C1 ist ein PCVD-Verfahren zur Herstellung eines auf der Innen- und/oder Außenfläche mit einem dielektrischen Schichtsystem versehen kalottenförmigen Substrat bekannt, bei dem vor der Beschichtung eine O₂-Gasentladung gezündet wird, um die zu beschichtende Kalotteninnenfläche zu konditionieren. Über die Intensität und Dauer der O₂-Gasentladung wird die gewünschte Substrattemperatur eingestellt. Es werden jedoch keine Angaben darüber gemacht, ob und wie die Aufheizphase überwacht wird, um die gewünschte Substrattemperatur sicherzustellen.

Aus der DE 4122452 A1 ist ein Verfahren und eine Vorrichtung zum Zünden von CVD-Plasmen bekannt. Das Plasma wird gasausgangsseitig der Reaktionskammer mittels einer zumindest kurzzeitig angelegten Hochspannung gezündet. Die Mikrowellenimpulse können zu deren Beginn kurzzeitig überhöht werden. Es ist u.a. ein Taktgenerator vorgesehen, der die zeitliche Korrelation von Zünd- und Mikrowellenimpulsen ermöglicht.

Alle bekannten Verfahren berücksichtigen jedoch nicht die spezifischen Anforderungen, die bei einer Innenbeschichtung von Hohlkörpern zu beachten sind.

Es ist daher Aufgabe der Erfindung, ein einfaches Verfahren zur Beschichtung von Hohlkörpern bereitzustellen, das es gestattet, die Eigenschaft und Qualität der Beschichtung schon während der Herstellung vorauszusagen. Es ist auch Aufgabe der Erfindung eine entsprechende Vorrichtung bereitzustellen.

Diese Aufgabe wird mit den Merkmalen des Patentanspruchs 1 gelöst. Die Vorrichtung ist Gegenstand des Patentanspruchs 4. Vorteilhafte Ausgestaltungen werden in den abhängigen Patentansprüchen beschrieben.

Es hat sich gezeigt, daß es bei der Herstellung von Sperrschichten entscheidend darauf ankommt, daß zu Beginn und während des Beschichtungsvorgangs eine bestimmte vorgegebene Temperatur eingehalten wird. Wenn diese Temperatur durch apparative Fehler zu niedrig liegt, wird zwar eine Sperrschicht abgeschieden, diese ist jedoch mehr oder weniger für Glaskomponenten, wie z.B. Natrium durchlässig. Im Falle von Diffusionsbarrieren auf Kunststoffkörpern hängt die Gasdiffusions-Sperrwirkung ebenfalls von der Beschichtungstemperatur ab. Es muß deshalb darauf geachtet werden, daß nach der Aufheizphase auch tatsächlich die gewünschte Beschichtungstemperatur erreicht worden ist.

Erfindungsgemäß wird ein Plasma-Impulsverfahren verwendet, bei dem das Plasma durch eine zeitliche Abfolge von Zündimpulsen gezündet wird, wodurch die Möglichkeit eröffnet wird, mindestens die Aufheizphase durch die Auswertung der zeitlichen Korrelation von Lichtimpulsen, die das Plasma aussendet, mit den Zündimpulsen zu überprüfen. Wenn Lichtimpulse ausbleiben sollten, ist davon auszugehen, daß durch den jeweiligen Zündimpuls das Plasma nicht gezündet wurde, mit der Folge, daß in der vorgegebenen Aufheizzeit, die beispielsweise zwischen 10 und 20 Sekunden liegt, nicht die gewünschte Temperatur erreicht wird. Anhand solcher Fehlimpulse laßt sich bereits in der Aufheizphase entscheiden, ob überhaupt die nachfolgende Beschichtungsphase angeschlossen werden soll oder nicht. Aus einer Zeitverzögerung der Lichtimpulse im Vergleich zu den Zündimpulsen können ebenfalls Rückschlüsse auf die zu erwartende Endtemperatur nach Abschluß der Aufheizphase gezogen werden.

Als weitere Fehlerquelle können beispielsweise undichte Ventile in den Zuleitungen für das Beschichtungsgas in Betracht kommen. Es ist daher erfindungsgemäß vorgesehen, daß die Intensität mindestens einer charakteristischen Emissionslinie des Beschichtungsgases bereits während der Aufheizphase gemessen und ausgewertet wird. Wenn aufgrund von Undichtigkeiten im Zuleitungssystem bereits während der Aufheizphase Beschichtungsgas in das Innere der Kammer eindringt, ist eine entsprechend ausgewählte Emissions-Linie einer Gaskomponente mehr oder weniger stark nachweisbar. Dies führt dazu, daß bereits zu einem Zeitpunkt, in dem noch nicht die gewünschte Endtemperatur erreicht ist, bereits eine Beschichtung stattfindet mit der Folge, daß diese Beschichtung nicht die gewünschte Qualität aufweist. Daran kann auch dann die spätere Beschichtung während der Beschichtungsphase nichts mehr ändern. Aus der Stärke der Intensität solcher bereits in der Aufheizphase auftretenden Emissionslinien des Beschichtungsgases kann auch auf die Endtemperatur geschlossen werden. Wenn derartige Emissionslinien bereits während der Aufheizphase besonders ausgeprägt vorliegen sollten, ist davon auszugehen, daß ebenfalls nicht die gewünschte Beschichtungstemperatur am Ende der Aufheizphase erreicht wird.

Durch die Kombination der Überwachung der zeitlichen Korrelation von Zünd- und Plasmaimpulsen sowie mindestens einer charakteristischen Emissionslinie des Beschichtungsgases nicht nur während der Beschichtungsphase, sondern bereits während der Aufheizphase ist es möglich, auf einfache Weise verläßliche Aussagen über die Qualität einer Innenbeschichtung zu machen.

Vorzugsweise wird das Plasma mittels Mikrowellen gezündet. Als Emissionslinie wird vorzugsweise die SiO-Linie detektiert.

Die Vorrichtung ist dadurch gekennzeichnet, daß die Plasmazündeinrichtung zur Erzeugung einer zeitlichen Abfolge von Zündimpulsen ausgebildet ist, daß die optische Nachweiseinrichtung zur Detektion von Lichtimpulsen und Emissionslinien des Plasmas ausgebildet ist und daß mindestens die Plasmazündeinrichtung und die optische Nachweiseinrichtung an eine Steuer- und Auswerteeinheit angeschlossen sind, die zur Auswertung der zeitlichen Korrelation von Zündimpulsen und Lichtimpulsen sowie zur Auswertung der Intensität von mindestens einer Emissionsline ausgebildet ist.

Vorzugsweise ist die Steuer- und Auswerteeinrichtung auch an mindestens ein Ventil in der Gaszuführleitung zur Beschichtungskammer angeschlossen.

Gemäß einer besonderen Ausführungsform ist die Plasmazündeinrichtung eine Mikrowelleneinrichtung.

Beispielhafte Ausführungsformen werden nachfolgend anhand der Zeichnungen näher erläutert.

Es zeigen:
- Fig. 1: eine schematische Darstellung der Beschichtungseinrichtung,
- Fig. 2: ein Temperatur-Zeitdiagramm, das den Einfluß eines fehlerhaften O₂-Plasmas zeigt,
- Fig. 3: ein weiteres Temperatur-Zeitdiagramm, das den Einfluß des vorzeitigen Einströmens des Beschichtungsgases zeigt,
- Fig. 4: ein Intensitäts-Konzentrationsdiagramm,
- Fig. 5: ein Diagramm, in dem der Natriumgehalt in einer im beschichteten Hohlkörper befindlichen Flüssigkeit in Abhängigkeit von der Beschichtungstemperatur aufgetragen ist.

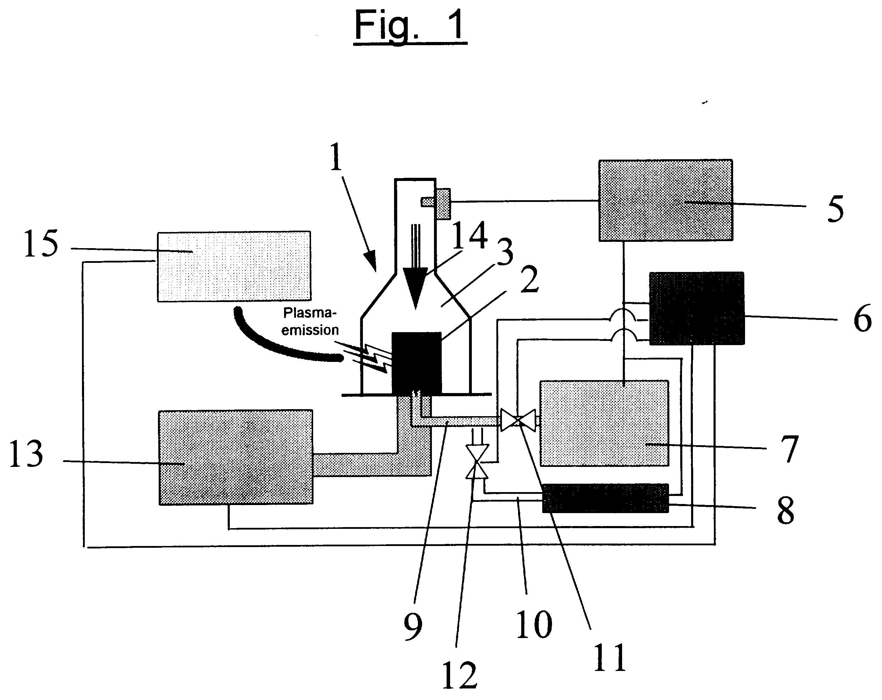

In der Figur 1 ist eine Beschichtungseinrichtung 1 dargestellt, in der eine zur Innenbeschichtung vorgesehen Flasche 2 in der Beschichtungskammer 3 angeordnet ist. Das Beschichtungsgas wird von einer Gasversorgungseinrichtung 7 über die Zuführleitung 9 von unten in die Beschichtungskammer 3 und somit in das Innere der Flasche 2 eingeleitet. An die Zuführleitung 9 ist eine weitere Zuführleitung 10 angeschlossen, die mit einer weiteren Gasversorgungseinrichtung 8 für die Zuführung von Sauerstoff verbunden ist. In den Leitungen 9 und 10 sind Ventile 11 und 12 angeordnet.

An die Beschichtungskammer 3 ist ferner eine Vakuumeinrichtung 13 angeschlossen. Das in der Flasche 2 befindliche Gas wird mittels einer Mikrowelleneinrichtung 5 gezündet. Die Mikrowellenstrahlung ist durch den Pfeil 14 gekennzeichnet.

Zum Nachweis der Lichtimpulse sowie einer oder mehrerer Emissionslinien des Plasmas ist eine optische Nachweiseinrichtung 15 vorgesehen, die ebenso wie die Versorgungseinrichtungen 7 und 8 und die Mikrowelleneinrichtung 5 an die Steuer- und Auswerteeinrichtung 6 angeschlossen sind. Ferner sind auch die Ventile 11 und 12 sowie die Vakuumeinrichtung 13 an die Steuer- und Auswerteeinrichtung 6 angeschlossen.

Der Beschichtungsvorgang läuft wie folgt ab:

Nachdem die innen zu beschichtende Flasche 2 in der Beschichtungskammer 3 angeordnet worden ist, wird mittels der Vakuumeinrichtung 13 die Beschichtungskammer 3 evakuiert. Anschließend wird das Ventil 12 an der Zuführleitung 10 geöffnet, so daß Sauerstoff aus der Versorgungseinrichtung 8 in das Innere der Flasche 2 einströmen kann. Hierbei ist das Ventil 11 in der Zuführleitung 9 geschlossen. Die Mikrowelleneinrichtung 5 zündet das O₂-Plasma, wobei während einer vorgegebenen Zeit von 20 sec eine Folge von Zündimpulsen von der Mikrowelleneinrichtung 5 erzeugt werden. Im Plasma entstehen Lichtimpulse, die von der optischen Nachweiseinrichtung 15 gemessen werden. Die Steuer- und Auswerteeinrichtung 6, die sowohl an die Mikrowelleneinrichtung 5 als auch an die optische Nachweiseinrichtung 15 angeschlossen ist, wertet die zeitliche Korrelation der Zündimpulse zu den Lichtimpulsen aus, um festzustellen, ob evtl. Lichtimpulse ausgeblieben sind oder eine Zeitverzögerung der Lichtimpulse im Vergleich zu den Zündimpulsen vorliegt. Falls diesbezügl. Abweichungen und Unregelmäßigkeiten auftreten, zeigt die Steuer- und Auswerteeinrichtung 6 eine Fehlermeldung an, aus der entnommen werden kann, daß die gewünschte Aufheizung der Flasche 2 nicht stattgefunden hat.

Die optische Nachweiseinrichtung ist auch zum Nachweis einer Emissionslinie des Beschichtungsgases ausgelegt. Über ein entsprechendes Linsen- und Filtersystem, das in der Figur 1 nicht dargestellt ist, das vorzugsweise auf die Wellenlänge von 425 nm eingestellt ist, wird während der Aufheizphase überprüft, ob die SiO-Linie auftritt oder nicht. Falls beispielsweise das Ventil 11 undicht sein sollte, würde während der Aufheizphase bereits Beschichtungsgas aus der Versorgungseinrichtung 7 in das Innere der Flasche 2 einströmen. Anhand des Nachweises der SiO-Linie kann diese Undichtigkeit erkannt werden. Auch in diesem Fall wird ein entsprechendes Signal von der optischen Nachweiseinrichtung 15 an die Steuer- und Auswerteeinrichtung 6 gegeben, die dann ebenfalls eine Fehlermeldung anzeigt.

Nachdem die Aufheizphase abgeschlossen ist und keine Fehlermeldung aufgetreten ist, wird das Ventil 12 in der Zuleitung 10 geschlossen und das Ventil 11 in der Zuführleitung 9 geöffnet. Es strömt anschließend Beschichtungsgas aus der Versorgungseinrichtung 7 in das Innere der Flasche 2 ein, und mittels der Mikrowelleneinrichtung 5 wird anschließend das Beschichtungsgas in der Flasche 2 gezündet. Die Auswertung der Lichtimpulse und der SiO-Linie wird während des Beschichtungsvorganges fortgesetzt, um auch während dieser Phase sofort Unregelmäßigkeiten erkennen zu können. Dadurch daß die Steuer- und Auswerteeinrichtung 6 auch an die Ventile 11 und 12 angeschlossen ist und die entsprechende Schaltstellung dieser Ventile registriert, wird erkannt, ob hier evtl. Undichtigkeiten vorliegen und somit der Beschichtungsvorgang erst gar nicht eingeleitet oder abgebrochen wird.

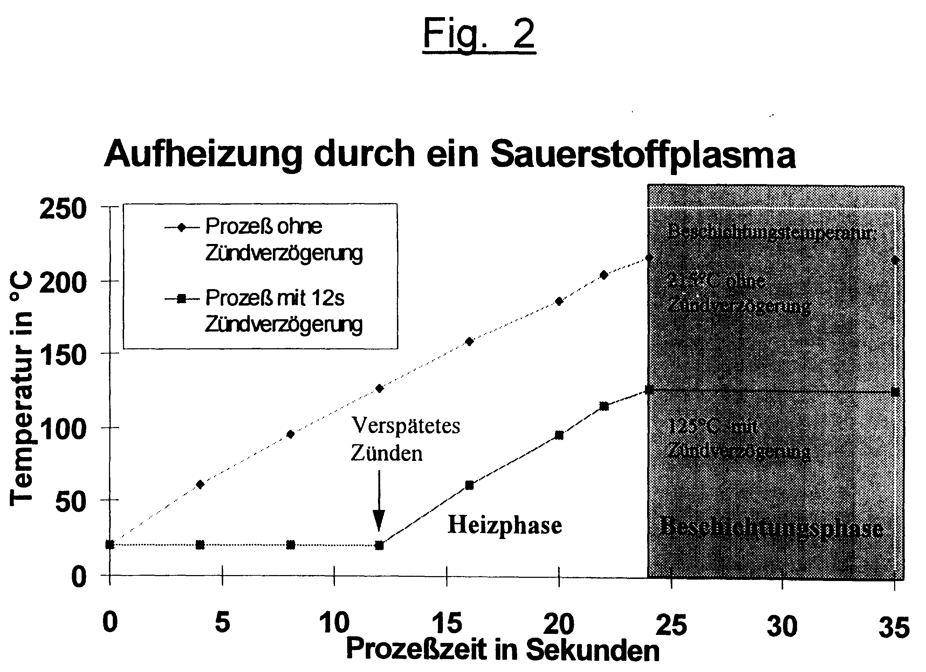

In der Figur 2 ist die Temperatur in Abhängigkeit von der Zeit aufgetragen. Zum Zeitpunkt 0 ist bereits der Sauerstoff in das Innere der Flasche eingeleitet, und das Plasma wird mittels der Mikrowellenimpulse gezündet. Dadurch steigt die Temperatur der Flasche kontinuierlich an, bis nach etwa 24 sec die gewünschte Beschichtungstemperatur von 215°C erreicht worden ist. Nach Abschluß der Heizphase wird das Beschichtungsgas eingeleitet und die Beschichtung durchgeführt, während der die Beschichtungstemperatur von 215°C beibehalten wird.

Sollte es zu Zündverzögerungen kommen, so daß, wie in der hier gezeigten Figur 2, beispielsweise erst nach 12 sec die Zündung des O₂-Plasmas stattfindet, so wird innerhalb der verbleibenden Zeit bis zum Beginn der Beschichtungsphase nur eine Temperatur von 125°C erreicht. Die Steuer- und Auswerteeinrichtung 6 erkennt dieses verspätete Zünden des Plasmas und gibt eine entsprechende Fehlermeldung ab. Die Aufheizphase müßte in diesem Fall dann entsprechend um weitere 12 sec verlängert werden, damit sichergestellt ist, daß tatsächlich die Beschichtungstemperatur von 215°C erreicht wird.

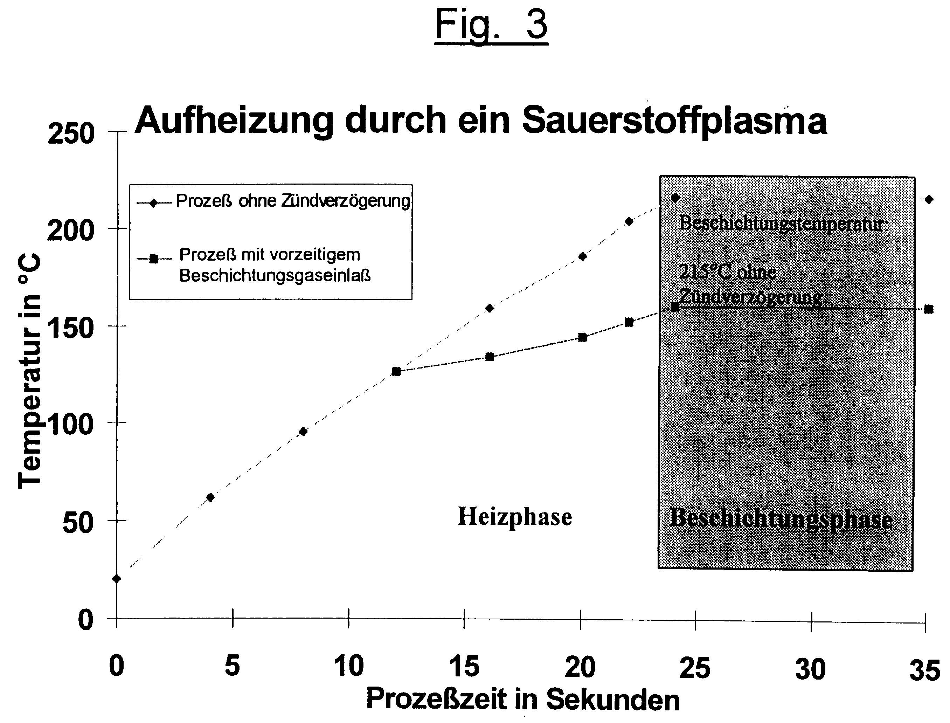

Wenn bereits in der Aufheizphase durch undichte Ventile Beschichtungsgas in die Beschichtungskammer eingeleitet wird, so wird die SiO-Linie detektiert. Die Folge der vorzeitigen Einleitung des Beschichtungsgases wirkt sich dahingehend aus, daß die vorgegebene Beschichtungstemperatur von 215°C nicht erreicht wird. In der Figur 3 ist zu sehen, daß etwa nach 13 sec Heizphase dieser fehlerhafte Einlaß des Beschichtungsgases stattfindet, so daß die Kurve entsprechend abknickt und nach den vorgesehenen 24 sec nur eine Temperatur deutlich unter 215°C erreicht.

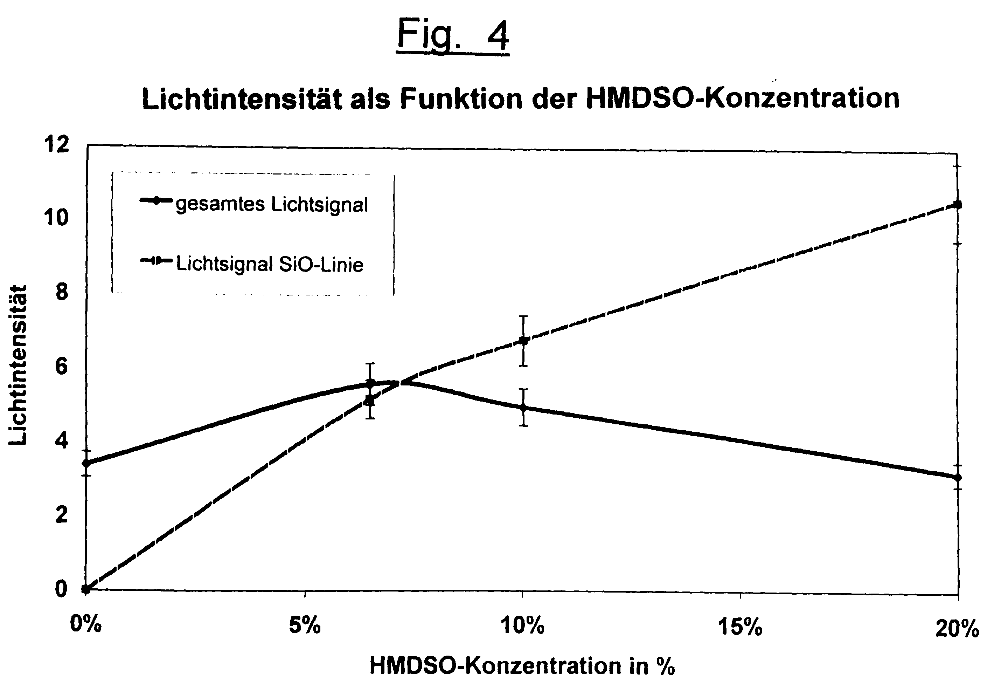

In der Figur 4 ist die Lichtintensität als Funktion der HMDSO-Konzentration aufgetragen.

Über die Intensität der SiO-Linie kann sofort erkannt werden, ob der HMDSO-Gehalt des Prozeßgases, der entscheidend die Qualität der abgeschiedenen SiO₂-Schicht bestimmt, den gewünschten Wert hat und beibehält. Dieser Effekt kann durch die Gesamtintensität allein nicht nachgewiesen werden, da die Gesamtintensität mit steigender HMDSO-Konzentration zunächst steigt und anschließend wieder fällt. Die Eindeutigkeit ist nicht gegeben.

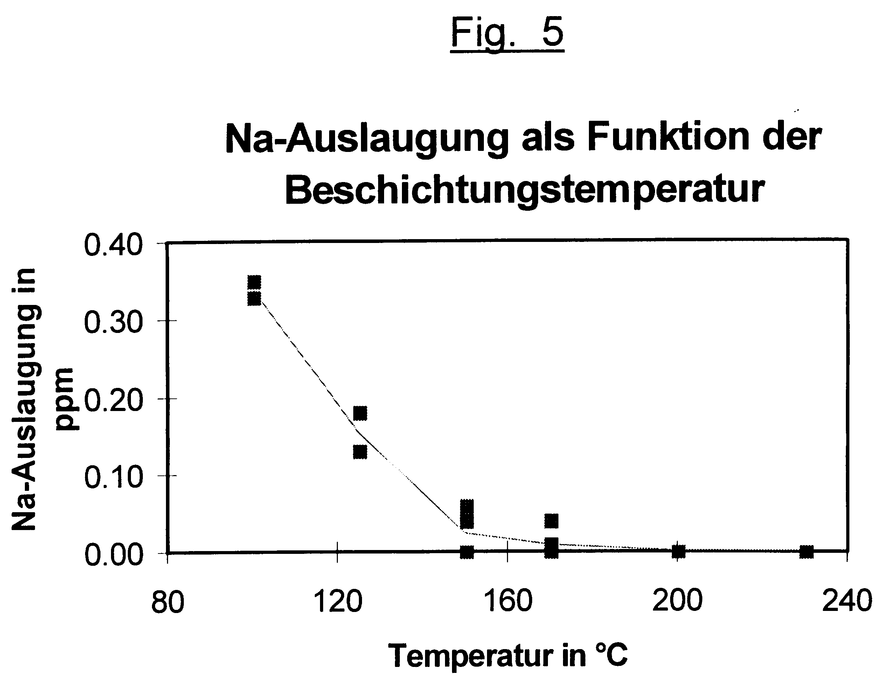

In der Figur 5 ist die Natriumauslaugung als Funktion der Beschichtungstemperatur aufgetragen. Die Auslaugung findet dann nicht statt, wenn die Beschichtungstemperatur mindestens 200°C beträgt. Für Temperaturwerte darunter, wie sie sich bei fehlerhafter Aufheizphase einstellen würden, wäre die Beschichtung für pharmazeutisches Packmaterial ungeeignet.

### Bezugszeichenliste

- 1: Beschichtungseinrichtung
- 2: Flasche
- 3: Beschichtungskammer
- 4: Mikrowellenstrahlung
- 5: Mikrowelleneinrichtung
- 6: Steuer- und Auswerteeinheit
- 7: Versorgungseinrichtung/Beschichtungsgas
- 8: Versorgungseinrichtung/O₂
- 9: Zuführleitung
- 10: Zuführleitung
- 11: Ventil
- 12: Ventil
- 13: Vakuumeinrichtung
- 14: Mikrowellenstrahlung
- 15: optische Nachweiseinrichtung

## Patentansprüche

1. CVD-Verfahren zur Innenbeschichtung von Hohlkörpern, wie Flaschen oder Ampullen, mit mindestens einer Sperrschicht, wobei der Hohlkörper vor der Beschichtungsphase, während das Beschichtungsgas in den Hohlkörper eingeleitet wird, in einer Aufheizphase mittels eines O₂-Plasmas auf eine vorgegebene Temperatur erwärmt wird, dadurch gekennzeichnet,
daß ein Plasma-Impulsverfahren verwendet wird, bei dem das Plasma durch eine zeitliche Abfolge von Zündimpulsen gezündet wird, und
daß sowohl während der Aufheizphase als auch während der Beschichtungsphase die zeitliche Korrelation der Lichtimpulse des O₂-Plasmas mit den Zündimpulsen sowie die Intensität mindestens einer Emissionslinie des Beschichtungsgases gemessen und ausgewertet wird.

2. CVD-Verfahren nach Anspruch 1, dadurch gekennzeichnet, daß das Plasma mittels Mikrowellen gezündet wird.

3. CVD-Verfahren nach Anspruch 1 oder 2, dadurch gekennzeichnet, daß die SiO-Emissionslinie detektiert wird.

4. Vorrichtung für die Innenbeschichtung von Hohlkörpern wie Flaschen, Ampullen oder dergleichen, mit einer Beschichtungskammer, einer Plasmazündeinrichtung, einer Gasversorgungseinrichtung und einer optischen Nachweiseinrichtung, dadurch gekennzeichnet,
daß die Plasmazündeinrichtung (5) zur Erzeugung einer zeitlichen Abfolge von Zündimpulsen ausgebildet ist,
daß die optische Nachweiseinrichtung (15) zur Detektion von Lichtimpulsen und Emissionslinien des Plasmas ausgebildet ist und
daß mindestens die Plasmazündeinrichtung (5) und die optische Nachweiseinrichtung (15) an eine Steuer- und Auswerteeinheit (6) angeschlossen ist, die zur Auswertung der zeitlichen Korrelation von Zündimpulsen und Lichtimpulsen sowie zur Auswertung der Intensität mindestens einer Emissionslinie ausgebildet ist.

5. Vorrichtung nach einem der Ansprüche 1 bis 4, dadurch gekennzeichnet, daß die Steuer- und Auswerteeinheit (6) an mindestens ein Ventil (11,12) in der Gaszuführleitung (9, 12) angeschlossen ist.

6. Vorrichtung nach einem der Ansprüche 1 bis 5, dadurch gekennzeichnet, daß die Plasmazündeinrichtung (5) eine Mikrowelleneinrichtung ist.

## Claims

1. CVD process for the internal coating of hollow bodies, such as bottles or ampoules, with at least one barrier layer, the hollow body being, before the coating phase, while the coating gas is fed into the hollow body, heated to a predetermined temperature in a heating phase using an O₂ plasma, characterized in that a plasma pulse process is used, in which the plasma is struck using a chronological sequence of striking pulses,
both during the heating phase and during the coating phase, the temporal correlation of the light pulses of the O₂ plasma with the striking pulses, as well the intensity of at least one emission line of the coating gas, is measured and evaluated.

2. CVD process according to Claim 1, characterized in that the plasma is struck using microwaves.

3. CVD process according to Claim 1 or 2, characterized in that the SiO emission line is detected.

4. Device for the internal coating of hollow bodies such as bottles, ampoules or the like, having a coating chamber, a plasma-striking instrument, a gas-supply instrument and an optical detection instrument, characterized in that
the plasma-striking instrument (5) is designed to generate a chronological sequence of striking pulses, and the optical detection instrument (15) is designed to detect light pulses and emission lines of the plasma, and
at least the plasma-striking instrument (5) and the optical detection instrument (15) are connected to a control and evaluation unit (6) which is designed to evaluate the temporal correlation of striking pulses and light pulses as well as to evaluate the intensity of at least one emission line.

5. Device according to one of Claims 1 to 4, characterized in that the control and evaluation unit (6) is connected to at least one valve (11, 12) in the gas feed line (9, 12).

6. Device according to one of Claims 1 to 5, characterized in that the plasma-striking instrument (9) is a microwave instrument.

## Revendications

1. Procédé CVD pour le revêtement intérieur de corps creux, comme des flacons ou des ampoules, par au moins une couche barrière, le corps creux étant chauffé au moyen d'un plasma à l'O₂ à une température spécifiée dans une phase de chauffage avant la phase de revêtement, pendant l'introduction du gaz de revêtement dans le corps creux, caractérisé en ce qu'on utilise
un procédé par impulsion de plasma dans lequel le plasma est allumé par une séquence temporelle d'impulsions d'allumage, et en ce que
à la fois pendant la phase de chauffage qu'aussi pendant la phase de revêtement, on mesure et on évalue la corrélation temporelle des impulsions lumineuses du plasma à l'O₂ avec les impulsions d'allumage, ainsi que l'intensité d'au moins une raie d'émission du gaz de revêtement.

2. Procédé CVD suivant la revendication 1, caractérisé en ce que le plasma est allumé au moyen de micro-ondes.

3. Procédé CVD suivant la revendication 1 ou 2, caractérisé en ce qu'on détecte la raie d'émission de SiO.

4. Installation pour le revêtement intérieur de corps creux, comme des flacons, des ampoules ou analogues, avec une chambre de revêtement, un dispositif d'allumage du plasma, un dispositif d'alimentation en gaz et un dispositif de détection optique, caractérisée en ce que
le dispositif d'allumage du plasma (5) est conçu pour produire une séquence temporelle d'impulsions d'allumage,
le dispositif de détection optique (15) est conçu pour détecter des impulsions lumineuses et des raies d'émission du plasma, et en ce que
au moins le dispositif d'allumage du plasma (5) et le dispositif de détection optique (15) sont reliés à une unité de commande et d'évaluation (6) qui est conçue pour évaluer la corrélation temporelle des impulsions d'allumage et des impulsions lumineuses, ainsi que pour évaluer l'intensité d'au moins une raie d'émission.

5. Installation suivant l'une des revendications 1 à 4, caractérisée en ce que l'unité de commande et d'évaluation (6) est reliée à au moins une soupape (11, 12) dans la conduite d'amenée du gaz (9, 12).

6. Installation suivant l'une des revendications 1 à 5, caractérisée en ce que le dispositif d'allumage du plasma (5) est un dispositif à micro-ondes.
